(19) Europäisches Patentamt
European Patent Office
Office européen des brevets

(11) EP 3 456 859 A1

(12) **EUROPEAN PATENT APPLICATION**

(43) Date of publication:
20.03.2019 Bulletin 2019/12

(51) Int Cl.:
*C23C 16/40* (2006.01)   *C23C 16/455* (2006.01)
*G04B 19/10* (2006.01)   *G04B 37/22* (2006.01)

(21) Application number: 17190822.1

(22) Date of filing: 13.09.2017

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ROLEX SA**
**1211 Genève 26 (CH)**

(72) Inventors:
• BOCCARD, Cyriaque
74140 Douvaine (FR)
• MULTONE, Xavier
1005 Lausanne (CH)
• DI LUNA, Pierre
74140 Douvaine (FR)
• ROULET, Alexandra
1213 Petit-Lancy (CH)

(74) Representative: **Gille Hrabal**
**Brucknerstrasse 20**
**40593 Düsseldorf (DE)**

(54) **PROTECTIVE COATING FOR A COMPLEX WATCH COMPONENT**

(57)   Provided is a method for protecting a complex watch component against gaseous environment, characterized in that the entire surface of the complex watch component or parts of said surface is/are coated with a protective coating by atomic layer deposition (ALD). Further provided are a method for obtaining a complex watch component, and a complex watch component comprising a protective ALD coating.

Fig. 1

10 nm

**Description**

The present invention relates to a method for providing a protective coating on a watch component comprising multiple parts (in the following designated as "complex watch component"), on all surfaces or a part of the surfaces of a complex watch component such as a complete dial. Further, the invention relates to complex watch components, in particular finished watch dials, provided with a protective coating. Preferably, these complex watch components having the protective coating are destined for after sales service or long time storage.

**Background of the invention / prior art**

Finished, ready to be mounted watch dials, comprising the decorated dial plate and the indexes and markings, are commonly stored under conditions which are neither air- nor watertight. In the after sales service, in subsidiary companies or at local retailers, they may be stored or transported under non controlled conditions. These conditions are really different and more soliciting than the ones watch dials shall be subjected to if they are to be inserted into a very high-quality waterproof watch. This has for consequence that the back of long term stored finished dials, even sometimes the visible face, may present, as the after sales service watchmaker wants to assemble one of them to a serviced watch, an aesthetical aspect that will not correspond to quality standards. It may follow scrapping of a component of high added value.

Coatings which are known for protection of watch parts are polymers, i.e. polymers based on poly(p-p-xylene) such as Parylene N, Parylene C etc. (CH 706 915 A). They are obtained via CVD and are used for protecting watch parts made of silver, gold, platinum, precious metals or alloys thereof against discoloration, dulling and corrosion which are caused by sulfur compounds present in sweat (such as $H_2S$) or gases present in the environmental air such as $SO_2$, $SO_3$, COS, $CS_2$, dimethyl sulfide.

The ALD technology has been known since the seventies. It has been studied more broadly since year 2000, limited to application for the food or semiconductor industries. This is described in the documents FR 2 797 995 A1 and *Atomic layer deposited protective coatings for micro-electromechanical systems* (N.D. Hoivik et al., Sensor and Actuators A 103 (2003) pp. 100-108).

Thin ALD layers, with thicknesses under a limit depending on several parameters, can be practically invisible.

The maximum thickness above which the ALD layer is visible can be a few atomic layers for metals, a few ten nanometers for some oxides, or several hundreds of nanometers for some multilayers oxides (like the one used for anti-reflective applications). For instance, layers of $TiO_2$ having a thickness of 60 nm on aluminum give the sample a light blue color. The visibility of the ALD layers or coatings thus depends very much on the type of layers, the chemical composition of the layer, the stacking of the deposited sub-layers, the layer or sub-layers thicknesses and the coating overall thickness, as well as on the roughness and color of the substrate.

The ALD deposition of oxide layers on watch parts is known e.g. from Atomic Layer Deposition (ALD): une technologie prometteuse pour l'industrie horlogère, D. Grange et al., SSC Bulletin no. 81, 43, May 2016.

The principles and advantages of the ALD method and the reaction mechanism are explained in detail in this document. In particular, monomolecular layers can be generated by this technique, thereby allowing a very controlled growth of the coating. If several layers are deposited on top of each other, a very dense coating can be obtained, with practically no pin-holes or defects. The ALD layers, according to this document, are applied for decorative purposes in the watch industry. In particular, it is reported that interference colors can be obtained by ALD by depositing a thin transparent layer, e.g. made of alumina, on a reflecting substrate that will present a new color, specific to the nature and thickness of the layer deposited. The method is suitable for coating very complex geometric shapes, since the reaction gases will reach each part of the substrate easily. According to this document, anti-reflective layers or coatings can be applied via ALD. Further, it is possible to combine the properties of different layers by applying several layers of different chemical natures to build a specific coating.

The ALD (Atomic Layer Deposition) technology is a variation of CVD (Chemical Vapor Deposition) techniques and involves chemisorption of chemical species issuing from gaseous precursors on the surface of the component.

The nature of the ALD coating is a function of the reagents introduced as gases, the so-called "precursors", in the deposition chamber, and is often constituted of several materials in a nanolaminated structure; i.e. layers of different chemical natures stacked on top of each other. The surface of the substrate to be coated is saturated with the first precursor, the chamber is purged afterwards by applying vacuum (pumping) and then the second precursor is injected to react with the first one and to create the first monolayer of the material constituting the coating.

ALD relies on a binary reaction sequence of self-limiting chemical reactions between gas phase precursors and a solid surface. Exposing a reactant R-A (R being any suitable residue) to the active sites of the surface results in the self-terminating adsorption of a monolayer of A species. The resulting surface becomes the starting substrate for the next step of the reaction. Subsequent exposure to molecule R-B (R being a suitable residue, which may be identical or different to that of R-A) will cover the surface with a monolayer of B species that combines with the A species to form the AB compound. Consequently, one cycle with reactants R-A and R-B injected successively deposits one monolayer of compound AB. By repeating the binary reaction sequence in an R-A/R-B/R-A/R-B fashion, a layer of AB compound of any thickness can be deposited. By adjusting the number of R-A/R-B cycles performed, the thickness of the AB layer can be controlled to the subnanometer level. Furthermore, because all the surface sites are reacting during each R-A/R-B cycle, the resulting AB layer is smooth, dense and pin-hole free. By allowing the gaseous reactant molecules to diffuse into voids and shadowed regions of the sample substrate, the ALD process enables substrates with complex geometries to be uniformly coated (N. D. Hoivik et al., Atomic layer deposited protective coating for micro-electromechanical systems, Sensor and Actuators A 103 (2003) pp. 100-108).

For an alumina layer ($Al_2O_3$), the typical reaction steps are as follows:

$$AlOH^* + Al(CH_3)_3 \rightarrow AlOAl(CH_3)_2^* + CH_4$$

$$AlCH_3^* + H_2O \rightarrow AlOH^* + CH_4$$

The first precursor R-A, TMA ($Al(CH_3)_3$, trimethylaluminum), is introduced into the reaction chamber and will react with the hydroxyl groups of the surface of the object to be coated, depositing Al-species on the surface and yielding methane as sub-reaction product. When all surface hydroxyl groups have reacted with TMA, the reaction stops. The remaining TMA and methane are purged by pumping. Then the second precursor R-B, water, is introduced and will react with the Al-species of the surface, forming $Al_2O_3$ and methane, which is removed together with remaining water during the second purge. By this reaction hydroxyl groups are formed on the covered surface again. After this cycle the surface is chemically uniform. The next monolayer can be provided in the same way in the next cycle. Alternating the two precursors will allow the constitution of a dense and continuous layer of $Al_2O_3$, the thickness of which will be controlled with precision by the number of cycles made.

The ALD layers can be typically constituted of a metal oxide, and/or metal nitride, and/or metal oxynitride. Of course, they could also be constituted of a carbide, and/or a carbonitride, and/or an oxycarbonitride, and/or be a sulfur containing layer. The ALD layers can be homogeneous layers (AB-AB-AB-...), regular alternate layers (n*AB-m*CD-n*AB-m*CD-...) or gradual layers (n*AB-CD-(n-1)*AB-2*CD-...2*AB-(m-1)*CD-AB-m*CD). The coating can be constituted either of a unique layer of any abovementioned type, or of a stacking of layers of any abovementioned type.

Thus, the layer/coating thickness will be controlled by the number of cycles, and layer/coating growth is exactly linear with the number of cycles.

The parameters for controlling the deposition are the nature of the precursor gases, the deposition temperature, the pulse duration (time during which the valve for introducing a precursor is opened, generally about 1 s, for alumina typically 0.1 s), and the purge duration (time between two pulses, allowing the reaction to proceed and to eliminate sub-reaction gases and the excess precursor).

The purge duration is essential for overall time required for deposition, and is typically between several seconds up to several tens of seconds, such as 60 to 90 s. The purge duration is in particular directly related to the deposition temperature: if the deposition temperature is low, the reaction is slower, and consequently the purge time has to be longer in order not to affect the quality of the coating.

The deposition temperature is the temperature of the substrate during the process which is identical to the temperature of the reaction chamber. The deposition temperature will also influence the quality and properties of the layer obtained. If the deposition temperature is lowered, the structure will lose its polycrystalline structure and will become amorphous. Typically, an alumina layer will be obtained using a deposition temperature of 300 °C, whereby a slightly polycrystalline structure is obtained. At this temperature, a complete cycle (two pulses and two purges) will be approximately 10 s. The layer will then grow by about 40 nm/h. However, alumina coatings can be deposited at temperatures as low as 35 °C (D. Grange et al., Atomic Layer Deposition (ALD): une technologie prometteuse pour l'industrie horlogère, Bulletin SSC no. 81, 43, Mai 2016).

For some precursors it is required to heat the precursors for introducing them as a gas.

For controlling the deposition, the choice of precursors is essential. For one and the same layer's composition, different precursors may be suitable. The choice of a particular precursor may depend on the nature of the substrate, the deposition temperature, the precursor's stability, costs or intended application of the layer to be deposited.

ALD technique is currently used in the watch industry to coat some specific components such as silicon-based components, for example a thermo-compensated balance spring (c. f. EP 3 002 638 A) or, more generally, other small watch components (e.g. EP 3 141 520 A). These documents disclose small micromechanical watch parts, in particular a silicon-based substrate, wherein pores are formed having a depth of less than 10 $\mu$m. These pores are either filled with carbon-diamond or $SiO_2$, SiN, ceramic or polymers, or are covered subsequently with a metallic layer of Cr, Ti, Ag, Pt, Cu, Ni, Pd, Rh, or a transparent oxide layer of $SiO_2$, $TiO_2$, $ZrO_2$, $HfO_2$, $Ta_2O_5$ or $VO_2$ for forming a decorative surface. ALD is mentioned among other techniques such as thermic oxidation, PVD or CVD for forming these decorative layers.

Spare parts in watch industry are commonly conditioned in little bags or under blisters, under vacuum or protective atmosphere, but more usually under air. Once opened, the protection of such a bag or blister is no longer efficient.

**Problems to be solved and solutions**

The invention proposes providing a protective coating on after sales service complex watch components that will protect the component against gaseous environment, from air, water and in general corrosion without altering its properties, especially its optical and geometrical properties.

Any conventional coating, such as lacquer or paint, deposited on a complete complex watch component, for instance on the back of a dial or even on all the dial's surfaces, will be too thick and may risk modifying the appearance or the dimensions of the component.

Appearance changes due to these conventional coatings can be seen directly after application and/or become more visible with the time, as these conventional coatings may get yellow when ageing. It is also mandatory that the deposited coating will not interfere with the required properties of the component in use, such as photoluminescence for example.

In the particular application of an assembled watch dial, the added value is very high and any aesthetic degradation, such as the oxidation of the back side of the dial or of an index, will lead to the scrapping of the dial. For dials that are still on fabrication, this may be only an economic problem, but for older dials that are not on the catalog anymore, but for which over 30 years of after sales service is assured, promising to replace them, it is necessary to supply a stockpile in order to avoid a remanufacturing of this component. This can be a complex process as some materials, machines or techniques used for the manufacturing of these components shall not be available anymore, or even forbidden by new ecological laws, such as electrodeposited gold alloys containing cadmium. Repair of a watch with such a dial would then become very complicated and expensive.

Therefore it is of utmost importance to reliably protect for a very long time watch components which are intended for after sales services against degradation such as for instance color changes or corrosion.

The solution for this problem provided by the present invention consists in the deposition of a very thin protective ALD coating on the surface of the watch component that will generate a barrier to the main gases and vapors that could react with the component in stores or storerooms. These environments may mainly contain oxygen, water vapor and sulfur-containing gases ($O_2$, $H_2O$ and $S_8$, $SO_2$, $SO_3$, $H_2S$, $CS_2$, dimethyl sulfide mainly).

The invention provides

[1] A method for protecting a complex watch component against gaseous environment, characterized in that the entire surface of the complex watch component or parts of said surface is/are coated by atomic layer deposition (ALD) with a protective coating, which is not visible by observation with the naked eye.

[2] A method for manufacturing a complex watch component by conducting usual steps for manufacturing the complex watch component, characterized in that a protective coating is applied by atomic layer deposition (ALD) at the end of the process to the entire surface or parts of the surface of the thus-obtained complex watch component, optionally followed by further applying a conventional coating, such as e. g. a Zapon coating.

Preferred embodiments of these methods are specified in claims 3 to 12.

The invention further provides a complex watch component, characterized in that the entire surface of the complex watch component or parts of said surface is/are coated with a protective coating formed by atomic layer deposition (ALD) obtainable by a process according to any of claims 1 to 12.

"ALD coating" means a coating that is obtained by atomic layer deposition (ALD). It may consist of one single ALD layer of a specified chemical composition or of a layer of a regular alternation of specific chemical compositions, deposited by ALD, or of any stacking of ALD layers of different chemical compositions and different thicknesses deposited by ALD.

Being deposited by the ALD technique, coatings may be so thin that they are practically invisible, i.e. imperceptible.

"Invisible" in the sense of the invention means that the presence of the protective ALD coating is not perceptible by observation with the naked eye. It could possibly, but not necessarily be noticed by directly comparing two watch components, one with a coating and one without, but it will not be apparent when a coated complex watch component of the invention is observed alone. In particular, "invisible" in the sense of the invention means that practically no color change is perceptible.

That is, according to the invention, color changes are considered to be invisible to the naked human eye below a value ΔELab of 1. If both parts, i.e. the finished watch component before applying the ALD coating and the ALD-coated watch component, are directly compared, color changes between 1 and 4 can be detected. For a ΔELab over 4, color change is perceptible event if parts are seen successively. ΔELab is defined according to EN ISO 11664-4 "Colorimetry-Part 4: CIE 1976 L*a'b* colour space".

This means also that color changes will be invisible as defined above even after long-term storage, unlike with conventional coatings such as Zapon that will get yellowish with time.

**Figures**

Fig. 1 shows a Transmission Electron Microscope (TEM) image at 300 kV of a cross-section of a dial coated in run 16 prepared by Focused Ion Beam (FIB).

Fig. 2 shows a TEM image at 300 kV of a cross-section of a dial coated in run 4 prepared by FIB. (1) denotes the substrate and (2) denotes the ALD coating ($TiO_2$, thickness 55 nm).

FIG. 3a shows photographs of a dial coated with only Zapon, before (T0) and after (T1) a 5 day exposition to sulfur vapor.

Fig. 3b shows photographs of a dial coated with ALD (in run 17) and Zapon (sample D2Z), before (T0) and after (T1) a 5 day exposition to sulfur vapor.

Fig. 4a and 4b show graphs of results of OTR (oxygen transmission rate) and WVTR (water vapor transmission rate) measurements obtained with different metal oxide coatings on polyimide films.

**Detailed description of the invention**

A complex watch component according to the invention can be any complex watch component which comprises at least two components or two parts made of different materials. That is, a complex watch component does not mean a monomaterial component. In particular it is a complex watch component which is intended for after sales service or long-term storage as a complete assembled part made of at least two components of different materials, as for example a finished watch dial with metallic indexes and ink markings or a finished watch dial with ink markings.

The ALD coatings of the invention have very low or no impact on the visible side' dial's aesthetic and will cover the complete dial, including the visible side with its decoration, drills, indexes, but also the back side and the dial feet.

Contrary to the conventional protection of watch components by bags or blisters, the gas barrier provided by the ALD coating of the invention allows a stable and sustainable protection against water vapor, oxygen and other gases.

"After sales service" of this kind of complex watch components means that a new complete complex component will be provided to repair service facilities or repair shops for repairing watches by replacing the deteriorated complete complex component. This is the case for dials, hands and winding crowns for example.

"Long-term" means up to 50 years, preferably at least 40 years, more preferably at least 30 years from the date of manufacturing the watch component.

In particular and preferably the watch component in this invention is a finished complete watch dial generally comprising a base plate of any geometric form suitable for a watch, i.e. circular, oval, rectangular, square, triangle, preferably circular, covered with any kind of decorative layer such as paint, lacquer, enamel, polymeric or metallic layer deposited by any known technique. It can also be covered with natural stone or other layers or coatings from a suitable material. It is optionally and preferably provided with numbers and/or indices/graduations marking the hours and/or minutes. It may comprise auxiliary dials for stopwatch, timer, second time zone, date etc. Further, the dial may comprise decorative elements such as, for example, inscriptions, engravings, precious stones such as diamonds, sapphires, emeralds, rubies and/or other precious stones. Numbers and/or indexes provided on the dial may be phosphorescent or fluorescent and/or photoluminescent by means of a corresponding layer provided on the surface of the number and or index.

The dial may be made of any material suitable for watch dials, such as technical fine ceramics, mother of pearl, stone, wood, carbon fibers, metal or metal alloys such as stainless steel, brass, nickel silver (German silver), bronze, precious metals such as silver, gold, platinum, any alloys thereof, silicon or high performance composite materials, for instance polymeric matrixes reinforced with any kind of fiber (glass, aramide, carbon).

The dial may be galvanized or covered with metal by electroplating for providing specific color impressions. For example, electroplated nickel, gold, silver, gold and copper layers can be provided on the dial, either alone or several different metal layers on top of each other. The dial may have two or areas of different colorings and/or may be formed of different materials.

The dial can be coated with a conventional coating such as Zapon, which is usually used in watch industry and which can give color depth to specific surfaces. The process of the invention can be applied to dials coated with such a conventional coating such as Zapon, or coated with any other conventional coating of that type known from the state of the art.

Zapon coating is a clear transparent coating (which may be colored, but mostly is colorless) commonly used for dials. Zapon coating is a liquid transparent acrylic varnish in volatile solvents. Zapon coating is commonly used for corrosion protection of metals such as brass or silver.

Moreover, a Zapon coating (or a comparable transparent coating) can be applied, as desired, after applying the ALD coating according to the invention in order to obtain a certain aesthetic effect such as deepening of the color.

A dial coated by conventional PVD, e.g. with an alumina coating, can also be additionally provided with a protective ALD coating of the invention, if desired.

Of course, the complex component, in particular the dial, can be made by any technique known from the state of the art.

Preferably all the surfaces of the complex component (such as the dial), i.e. the entire surface of the watch component, will be coated by the ALD coating according to the invention. In particular front side, back side, sides, holes, drills, as well as all protruding and/or recessing parts, including decorative elements, inscriptions, indices, numbers, marks, engravings, if present, are covered by the ALD coating according to the invention.

However, with common masking techniques the ALD coating can be limited to some areas only. This embodiment is also within the scope of the invention.

Other complex watch components of the invention are hands, movement blanks, crowns and the like.

According to the invention, a complete complex watch component to be protected by the ALD coating is first manufactured in a usual way well-known to the skilled person. Thereafter, the desired protective coating is applied on the complete complex finished watch component by means of ALD, or on parts thereof using conventional masking techniques. The ALD is carried out in a known manner by using process conditions well known by the skilled person. The process conditions and precursors are selected from conventionally known ones according to the layer to be provided.

Any commercially available ALD device can be used according to the invention. The processing temperature is usually from 30 to 500 °C. The cycle time can be controlled according to need and is down to 1 second, which is the smallest time unit which can be controlled precisely in usual ALD apparatus. The precursors may be liquid, solid, or gaseous according to the ALD device manufacturer.

Layers of $Al_2O_3$ and/or $SiO_2$ and/or $Ta_2O_5$ and/or $HfO_2$ and/or ZnO and/or $TiO_2$ and/or $ZrO_2$ and/or AIN and/or TaN and/or TiN can be made according to the invention using this device. Preferably, layers of aluminum oxide (alumina, $Al_2O_3$), titanium oxide ($TiO_2$), tantalum oxide ($Ta_2O_5$) and/or alternating nanolaminated layers of aluminum oxide and titanium oxide ($Al_2O_3/TiO_2$) can be deposited onto the complete watch component according to the invention.

Indeed, it is possible to combine different layers to achieve the protective effect. By different layers, we mean layers of different chemical natures, different densities, and/or different reflection indices. By different stacking of these different layers, with different individual thicknesses, it results in a multitude of so-called nanolaminated coatings possibilities.

The following precursors and temperatures of the precursors are preferably employed according to the invention:

TMA (trimethylaluminum) introduced at ambient temperature,
TDMATi (tetradimethylaminotitanium) introduced at 73 to 80°C,
TBTEMTa (tert-butylimido)tris(ethylmethylamido)tantalum) introduced at 90 to 100°C,
$TiCl_4$ (titaniumtetrachloride) introduced at ambient temperature.

Precursor's temperature is chosen between a minimal temperature that will ensure vaporization of the precursor and a maximal temperature above which the precursor is degraded.

The chamber's temperature, and consequently the substrate's temperature and the deposition's temperature, is preferably chosen between 120°C and 200°C, preferably at 150°C, and maintained during all the process. If chamber's temperature is too low, the precursor gas will condense. If it is too high we quit the ALD regime for CVD, the reaction could occur in the chamber and not on the substrates' surface anymore, and there will be no more self-limitation of the reaction to one monolayer.

The technical lower limit for ALD layer thickness is one monolayer of the molecule AB. For the ALD coating of one embodiment of the invention, the coating has an OTR (oxygen transmission rate) smaller or equal to that of conventional Zapon coating, which is around 56 $cm^3/(m^2 \cdot 24 \, h)$.

The upper limit, to remain in the perimeter of the application, which requires the protective coating to be imperceptible to the eye, depends on the exact configuration of the coated component. It will also depend on the color, topography and roughness of the watch component to be coated, and on the chemical nature and stacking of the ALD individual layers constituting the coating.

Preferably, a coating thickness of 100 nm should not be exceeded in order to avoid a visible color change of the surface caused by the ALD coating. Preferably, the thickness of the ALD coating formed according to the invention is 95 nm or below, more preferably 60 nm or below, even more preferably 50 nm or below. It may even be 1 nm or monomolecular. However, generally 5 nm is appropriate as lower limit of the coating thickness, being sufficient to start to protect the substrate, and 100 nm is appropriate as higher limit as a thicker coating will not improve much the result. Thicker coatings could be designed, as long as they fulfill the criteria of not modifying the initial aspect of the substrate.

Coating thickness means overall thickness of the ALD coating deposited on the complex watch component. Layer thickness means thickness of a single compound layer; in case of a regular alternation of sub-layers having a different composition, layer thickness may also mean the thickness of the layer presenting this regular alternation. The coating's thickness is determined by ellipsometry as described below. The thicknesses of layers stacked to constitute a coating have to be determined by TEM observations.

In case of a coating made of multiple ALD layers, the thickness of each layer may be the same or different according to the invention.

In case of alternating ALD layers, such as e.g. alternating titanium oxide and alumina, the number of single alternating layers is basically not important. It is preferably 1 to 10, more preferably 5 to 8.

The coating time is usually 0,1 to 380 min, but it is selected according to the desired coating thickness.

**Examples**

All coatings of the examples have been deposited in a PICOSUN® P-300B ALD or in a R200 Advanced ALD device, at a temperature of 150°C, using TMA (introduced at ambient temperature), TDMATi (introduced at 80°C), TBTEMTa (introduced at 90°C) and $TiCl_4$ (introduced at ambient temperature), as precursors at the respective precursor temperatures. The conditions of ALD deposition and description of the coatings are summarized in Table 1.

Each sample is related to a specific deposition run and identified with a sample number if substrate is a polyimide film. Due to the encapsulating nature of the ALD technique, polyimide films coated for OTR and WVTR measurements are coated on both sides. Some runs were conducted on folded polyimide film glued together with adhesive tape, so as to measure properties corresponding to the layer's thickness that would be deposited on a dial. OTR and WVTR were measured on the unfolded film, and these samples are identified with "-1".

**Table 1 : run conditions and sample description**

| Run Nr | Layer type | Precursor 1 | Precursor 2 | Nr cycles | Coating thickness [nm] | Sample Nr | Time (indicative) [min] |
|---|---|---|---|---|---|---|---|
| 1 | $Al_2O_3$ | TMA | $H_2O$ | 200 | 23 | 1 | 60 |
| 2 | $Al_2O_3$ | TMA | $H_2O$ | 500 | 57 | 2 | 150 |
| 3 | $TiO_2$ | TDMATi | $H_2O$ | 444 | 24 | 3 | 150 |
| 4 | $TiO_2$ | TDMATi | $H_2O$ | 1111 | 54 | D, 4 | 360 |
| 5 | $Ta_2O_5$ | TBTEMTa | $H_2O$ | 600 | 59 | 5 | 200 |
| 6 | $Ta_2O_5$ | TBTEMTa | $H_2O$ | 1 | 0 (1ML) | 6-1 | 0.3 |
| 7 | $Ta_2O_5$ | TBTEMTa | $H_2O$ | 11 | 1 | 7,7-1 | 3.6 |
| 8 | $Ta_2O_5$ | TBTEMTa | $H_2O$ | 16 | 1.5 | 8-1 | 5.3 |
| 9 | $Ta_2O_5$ | TBTEMTa | $H_2O$ | 32 | 3 | 9 | 11 |
| 10 | $Ta_2O_5$ | TBTEMTa | $H_2O$ | 54 | 5 | 10 | 18 |
| 11 | $Ta_2O_5$ | TBTEMTa | $H_2O$ | 106 | 10 | 11 | 35 |
| 12 | $Ta_2O_5$ | TBTEMTa | $H_2O$ | 213 | 22 | 12 | 71 |
| 13 | $Ta_2O_5$ | TBTEMTa | $H_2O$ | 320 | 32 | 13 | 107 |
| 14 | $Ta_2O_5$ | TBTEMTa | $H_2O$ | 1052 | 97 | 14-1 | 350 |

(continued)

| Run Nr | Layer type | Precursor 1 | Precursor 2 | Nr cycles | Coating thickness [nm] | Sample Nr | Time (indicative) [min] |
|---|---|---|---|---|---|---|---|
| 15 | $Al_2O_3/TiO_2$ | TMA / TDMATi | $H_2O$ / $H_2O$ | 2•(50+111) | 23 | 15 | 90 |
| 16 | $Al_2O_3/TiO_2$ | TMA / TDMATi | $H_2O$ / $H_2O$ | 5•(50+111) | 58 | D1, 16 | 240 |
| 17 | $Al_2O_3/TiO_2$ | TMA / $TiCl_4$ | $H_2O$ / $H_2O$ | 8•(50+111) | 95 | D2, D2Z, 17 | 380* |

| * = not measured; calculated based on previous data of other experiments |
|---|
| ML = monolayer |

Coating thickness has been measured by ellipsometry. The equipment is a Semilab® S-2000. The measurements are performed in ultra-violet, visible and near infra-red wavelengths. The integration time is 5 seconds and the incidence angle is 70°. The measurement type is PsiDelta.

Transmission Electron Microscopy (TEM) has been carried out in a Titan® 80-300, FEI, to perform bright field images at 300 kV, with a diaphragm objective of 40 $\mu$m. The samples have been prepared with a Focused Ion Beam (FIB) Strata® 400, FEI. Thicknesses of some coatings have also been measured on these images, as well as the control of their conformal characteristics.

When permeation measurements are performed, the ALD coatings are deposited on polyimide film. As coating can be present on one or both sides of the polyimide film, the tested thickness of the ALD coating is specifically mentioned in the results.

In the first embodiment, two materials are deposited alternatively in a nanolaminated structured layer. Brass dials, previously coated with metallic layers by electroplating in a conventional manner, and polyimide films have been coated with an ALD coating made of an alternation of $Al_2O_3$ and $TiO_2$ layers, from precursors TMA / $TiCl_4$ + $H_2O$ / $H_2O$ at a deposition temperature of 150°C.

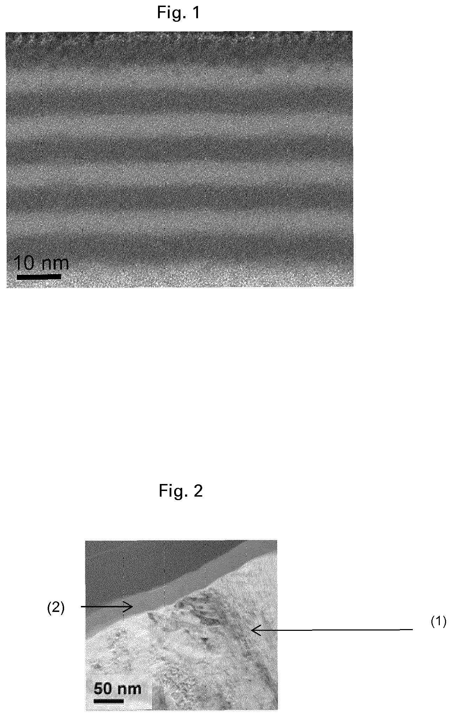

In the first variant, sample D1, a finished brass dial coated with metal layers and showing a pink color, has been coated with five alternations of $Al_2O_3$ and $TiO_2$ layers (Run 16 of Table 1). Coating thickness is 58 nm. A TEM image of a FIB prepared cross-section of sample D1 is shown in Fig. 1. The alternating uniform dense layers are clearly visible.

In a second variant, samples D2 and D2Z, two brass dials with a silver electroplated layer, have been coated by ALD, with a similar layer structure (defined by the nature of the layers in alternation, as well as their individual thicknesses) as in the first variant, but of a total thickness of 95 nm, with eight alternations of $Al_2O_3$ and $TiO_2$ instead of five (Run 17 of Table 1).

The color change between such silver-plated brass dials with no coating, with only Zapon coating, with only ALD coating (sample D2) and with both ALD and Zapon coating (sample D2Z) has been measured by spectrocolorimetry (specular reflection included) and is expressed in the CIELab reference space. The equipment is a Minolta® CM-3610d, with lightening with standard day light D65, observation angle at 10°, and diaphragm diameter of 7 mm.

**Table 2: color change on dials.**

| Designation | Description of the layers | Coating thickness [nm] | L* | a* | b* | $\Delta$ELab |
|---|---|---|---|---|---|---|
| Ag dial | none | 0 | 99.4 | -0.3 | 2.7 | Reference |
| Z | Zapon | 8000 | 97.5 | -0.8 | 10.0 | 7.6 |
| D2 | $Al_2O_3/TiO_2$ | 95 | 97.7 | -0.8 | 4.2 | 2.3 |
| D2Z | $Al_2O_3/TiO_2$ + Zapon | 95 + 8000 | 96.2 | -0.3 | 5.1 | 4.0 |

Color changes are considered to be invisible to the human eye under a value $\Delta$ELab of 1. If both parts are directly compared, color changes $\Delta$ELab between 1 and 4 can be detected. For a $\Delta$ELab above 4, color change is perceptible even if parts are observed successively. In comparison to Zapon, the ALD coating only modifies little the perception of the base color. It even lowers the color change of a dial with Zapon if applied before the Zapon layer.

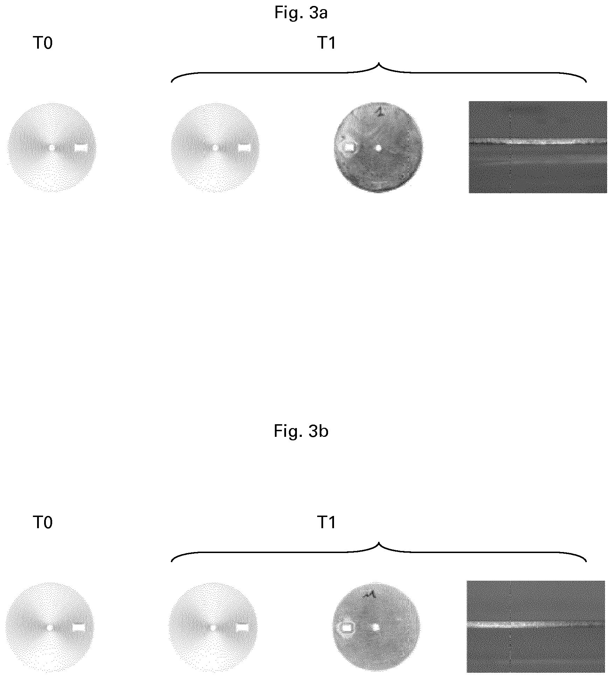

In order to verify the protective effect of this coating, an exposition to sulfur vapor has been conducted on dials, coated with only Zapon (traditional process, sample Z) or with an ALD nanolaminated layer $Al_2O_3/TiO_2$ deposited according to run 17 previously to the Zapon layer (sample D2Z). The dials are exposed to 1 g of sulfur in an atmosphere with 95% of relative humidity, at 30°C. Exposition time can be from 1 day to 5 days. The results of the test are shown in Fig. 3a) and Fig. 3b).

It can be observed that the back and side of the dial coated with Zapon (sample Z) only on the upper surface are degraded by the sulfur in the test. To the contrary, as the ALD coating covers all surfaces, the back and the sides of the ALD+Zapon dial of the invention (sample D2Z) are perfectly clean and preserved after the test.

The dial D2Z is perfectly protected from the sulfur vapor by the ALD coating, on all surfaces. The coating is overall and follows perfectly the surface of the substrate. It allows a complete encapsulation of the part.

Reading these results, the ALD coating could advantageously replace the Zapon in a protective point of view.

Nevertheless, as Zapon offers the aesthetic advantage to give depth to some decor of the dial, the ALD coating can be applied in addition to Zapon; in practice, it can be deposited before or after the Zapon. Process and nature of the ALD coating are compatible with such a polymeric layer.

This means that already stored dials coated by conventional Zapon can be treated by the ALD technique according to the invention, and no specific preparation is needed.

Complementary experiments have been performed to show the correlation between the results of resistance to sulfuration obtained on dials and permeability measurements performed on polyimide films coated with the same coating. These tests have allowed to define the thickness limits to be an efficient gas-barrier with no coloration induced.

Oxygen Transmission Rate (OTR) and Water Vapor Transmission Rate (WVTR) are the two values used for the evaluation of the results. They will allow easy and quantitative comparison of different chemical natures and different structures of coatings, as well as different thicknesses of the ALD coatings tested.

OTR has been measured with a Mocon Oxtran® model 2/61 equipment. The measurement area is 10 cm$^2$, the temperature 23 °C, the humidity 50%, the $N_2$ flux 10 sccm (standard cubic centimeters per minute), the $O_2$ flux 50 sccm, the oxygen partial pressure $10^5$ Pa. A measurement is performed during 30 minutes, every 5 hours, until stabilization.

WVTR has been measured in a Systech® 7001 equipment. The measurement area is 50 cm$^2$, the temperature 23 °C, the humidity 50%, the $N_2$ flux 10 sccm, the $N_2$ humid flux 20 sccm. A measurement is performed every 30 minutes.

A polyimide film of Kapton-HN® 75 micrometer thick (manufactured by DuPont®) has been used as a substrate for the measurements of permeation. This kind of film is permeable to water vapor and oxygen, as shown in the table below. The conventional Zapon coating is also permeable to oxygen, and to water vapor in a limited manner.

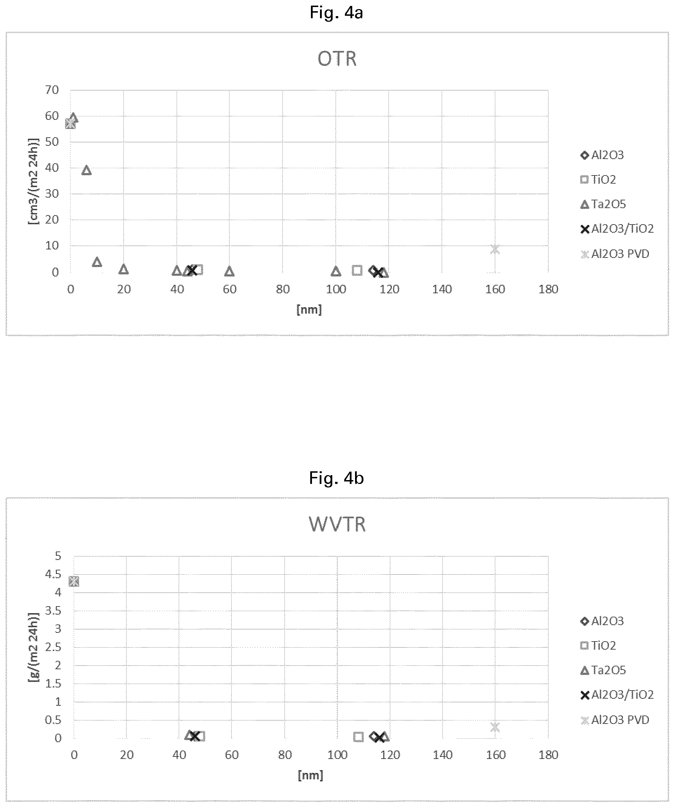

Polyimide films have been coated by ALD with same runs as dials (samples D1 and D2/D2Z), resulting in samples 15 and 16. As ALD is an encapsulation technique, these samples present a global thickness of the ALD deposited material that is twice the thickness of the coating on the dial's visible face, as the coating is present on both sides of the film. The test results are expressed in Transmission Rate in [cm$^3$/(m$^2$ 24h)] for OTR and in [g/(m$^2$ 24h)] for WVTR and summarized in Table 3 and shown also in Fig. 4a and 4b. They show a direct correlation between the results of the resistance to sulfuration and the presence of the ALD coating.

**Table 3 : Transmission Rate results for alternate $Al_2O_3/TiO_2$ type coatings.**

| Designation | Coating structure and chemical nature | Coating thickness [nm] | OTR [cm$^3$/(m$^2$ 24h)] | WVTR [g /(m$^2$ 24h)] |
|---|---|---|---|---|
| Kapton-HN® | none | 75'000 | 58±2 | 4.3 |
| Zapon | Zapon | 8000 | 57±2 | 3.5 |
| 15 | $Al_2O_3/TiO_2$ | 46 (2x23) | 0.73 | 0.054 |
| 16 | $Al_2O_3/TiO_2$ | 116 (2x58) | < detection limit | 0.042 |

Other kinds of ALD coatings can fulfill the same function with the same or even better efficiency. It is possible to combine different layers to achieve the same protective effect. Different layers mean different chemical natures, different densities, different reflection indexes. Layers of different thicknesses can be included in the final coating. By a combination of these different layers, with different thicknesses and stackings, a multitude of nanolaminated coatings possibilities can be obtained.

As OTR and WVTR are measurable values, all tested coatings, including $Al_2O_3/TiO_2$, have been applied on polyimide films in order to quantify the real permeability of the coating.

A polyimide sheet of Kapton-HN® 75 micrometer thick (manufactured by DuPont) has been used as a substrate for these measurements of permeation, as in the above-described samples. The measurements have been carried out as described above.

If not specified, runs have been performed on single Kapton-HN® sheets. In Runs 6, 7, 8 and 14, folded Kapton-HN® sheets have been coated in order to allow measurement of thinner ALD coatings by unfolding the polyimide film to have samples with only one coated side for the OTR/WVTR measurements.

A 160 nm thick PVD-MS (Physical Vapor Deposition Magnetron Sputtering) coating of $Al_2O_3$ and a 8 micrometer-thick Zapon coating have also been tested as comparison values.

### Pure $Al_2O_3$ coating

In a first variant of the second embodiment, pure $Al_2O_3$ coatings are deposited by ALD from TMA and $H_2O$ precursors, injected alternatively. 200 cycles (Run 1) allow a thickness of 23 nanometers to be built, 500 cycles (Run 2) lead to a 57 nanometers thick layer, perfectly compact and conform to the surface of the sample.

Permeation measurements carried out as described above confirm the tightness of the layer against oxygen and water vapor, with OTR and WVTR values detailed in Table 4 and shown also in Fig. 4a and 4b.

**Table 4: Transmission Rate with an $Al_2O_3$ coating.**

| Designation | Chemical nature | Thickness [nm] | OTR [$cm^3/(m^2\,24h)$] | WVTR [$g/(m^2\,24h)$] |
|---|---|---|---|---|
| Kapton-HN® | none | 75000 | $58\pm2$ | 4.3 |
| Zapon | Zapon | 8000 | $57\pm2$ | 3.5 |
| $Al_2O_3$ PVD-MS | $Al_2O_3$ | 160 | 8.7 | 0.3 |
| 1 | $Al_2O_3$ | 46 (2x23) | 1.03 | 0.039 |
| 2 | $Al_2O_3$ | 114 (2x57) | 0.79 | 0.047 |

It is apparent here that the ALD technique is more efficient than the PVD technique to deposit coatings with good tightness characteristics. The advantage of ALD over PVD is that the layer is conformal to the surface and no pin-holes are created. The ALD also allows to obtain conformal coating whereas special implementation and specific sample holders are needed to perform a 3D coating by PVD. With such a technical adaptation of the equipment and fitting of coating thickness, PVD could reach comparable results but with extra costs and a complicated process.

### Pure $TiO_2$ coating

In a second variant of the second embodiment, pure $TiO_2$ coatings are deposited by ALD from TDMATi and $H_2O$ precursors, injected alternatively. 444 cycles (Run 3) allow a thickness of 24 nanometers to be built, 1111 cycles (Run 4) lead to a 54 nanometers thick layer, perfectly compact and conform to the surface of the dial, as it can be observed on the TEM image shown in Fig. 2, on a FIB prepared cross-section of a sample D, also coated in run 4.

Permeation measurements confirm the tightness level of the layer against oxygen and water vapor, with OTR and WVTR values (measured as described above) and detailed in Table 5 and shown also in Fig. 4a and 4b.

**Table 5: Transmission Rate with a $TiO_2$ coating.**

| Designation | Chemical nature | Thickness [nm] | OTR [$cm^3/(m^2\,24h)$] | WVTR [$g/(m^2\,24h)$] |
|---|---|---|---|---|
| Kapton-HN® | none | 75000 | $58\pm2$ | 4.3 |
| Zapon | Zapon | 8000 | $57\pm2$ | 3.5 |
| 3 | $TiO_2$ | 48 (2x24) | 1.05 | 0.058 |
| 4 | $TiO_2$ | 108 (2x54) | 0.71 | 0.035 |

### Pure $Ta_2O_5$ coating

In a third variant of the second embodiment, pure $Ta_2O_5$ coatings are deposited by ALD from TBTEMTa and $H_2O$ precursors, injected alternatively (Runs Nr 5 to 13). The relation between cycle number, thickness and results is shown in Table 6, and variations of OTR / WVTR are detailed in Fig. 4a and 4b.

The tightness level of the $Ta_2O_5$ coating against oxygen and water vapor is confirmed even for very thin layers, starting at about 6 nm of $Ta_2O_5$.

Table 6: Transmission Rate with a $Ta_2O_5$ coating.

| Designation | Chemical nature | Thickness [nm] | OTR [cm$^3$/(m$^2$ 24h)] | WVTR [g/(m$^2$ 24h)] |
|---|---|---|---|---|
| Kapton-HN® | None | 75'000 | 58±2 | 4.3 |
| Zapon | Zapon | 8'000 | 57±2 | 3.5 |
| 6-1 | $Ta_2O_5$ | 0 (1 ML) | 59.7 | * |
| 7-1 | $Ta_2O_5$ | 1 | 59.4 | * |
| 8-1 | $Ta_2O_5$ | 1.5 | -60.6 | * |
| 9 | $Ta_2O_5$ | 6 (2x3) | 39.2 | * |
| 10 | $Ta_2O_5$ | 10 (2x5) | 3.9 | * |
| 11 | $Ta_2O_5$ | 20 (2x10) | 1.2 | * |
| 12 | $Ta_2O_5$ | 44 (2x22) | 0.7 | 0.08 |
| 13 | $Ta_2O_5$ | 64 (2x32) | 0.5 | * |
| 14-1 | $Ta_2O_5$ | 97 | 0.4 | * |
| 5 | $Ta_2O_5$ | 118 (2x59) | < detection limit | 0.04 |

* = not determined
ML = Monolayer

Results on samples 6-1, 7-1, 8-1 and 14-1 have been obtained on single side coated polyimide sheets. The film is folded and the sides are assembled together with adhesive tape (Kapton® Polyimid-Film - Type 300 HN, 0.075 mm thick) before the ALD coating. The film is then unfolded and only one half, with a single side coated, is used for the OTR measurement. All other results have been obtained on double side coated polyimide sheets.

These more detailed values show that the minimal thickness to observe a protective effect is 5 nm, preferably 6 nm, preferably 10 nm, depending on the coating's nature. For any kind of the ALD coatings tested, the protective effect can be considered as complete from 50 nm and above. As color change will increase as the thickness of the coating increases, by interferential effect, usually such protective coatings don't go over 100nm thick. The only upper limit here is the tolerance to color change, which will concretely be depending on the nature and color of the substrate. For our application and so as to keep as close as possible to the initial dial color, ALD coatings are limited to 100 nm to avoid average color change ΔELab going over a value of 4.

**Claims**

1.   A method for protecting a complex watch component against gaseous environment, **characterized in that** the entire surface of the complex watch component or parts of said surface is/are coated by atomic layer deposition (ALD) with a protective coating.

2.   A method for manufacturing a complex watch component by conducting usual steps for manufacturing the complex watch component, **characterized in that** a protective coating is applied to the entire surface or parts of the surface of the thus-obtained complex watch component by atomic layer deposition (ALD), optionally preceded or followed by applying a conventional coating.

3.   The method according to claim 1 or 2, wherein the watch component is a finished watch dial.

4.   The method according to any of claims 1 to 3, wherein the protective coating is not visible by observation with the naked eye.

5.   The method according to any of claims 1 to 4, wherein the color difference ΔELab between the complex watch component before ALD coating and the ALD-coated complex watch component is lower than 4, preferably lower than 1.

6. The method according to any of claims 1 to 5, wherein the complex watch component is intended for after sales service and/or long-term storage.

7. The method of any of claims 1 to 6, wherein the ALD coating comprises one or more layers, which may be identical or different, selected from metal oxide, metal nitride, metal oxycarbonitride, metal carbonitride, and metal sulfide layers.

8. The method of any of claims 1 to 7, wherein the ALD coating comprises one or more identical or different metal oxide layers.

9. The method of claim 8 wherein the one or more metal oxide layers are selected from $Al_2O_3$, $TiO_2$, $Ta_2O_5$ layers and/or a combination of layers of $Al_2O_3$ and $TiO_2$.

10. The method according to any of claims 1 to 9, wherein the gaseous components in the environment are water vapor and/or oxygen and/or sulfur-containing compounds.

11. The method according to any of claims 1 to 10, wherein the thickness of the ALD coating is at least one atomic monolayer, preferably at least 5 nm.

12. The method according to any of claims 1 to 11, wherein the thickness of the ALD coating is from one atomic monolayer to 100 nm, preferably from 6 nm to 100 nm and most preferably from 6 nm to 50 nm.

13. A complex watch component, **characterized in that** the entire surface of the complex watch component or parts of said surface is/are coated with a protective coating formed by atomic layer deposition (ALD), the complex watch component being obtainable by a process according to any of claims 1 to 12.

Fig. 1

Fig. 2

Fig. 3a

T0                                          T1

Fig. 3b

T0                                          T1

## Fig. 4a

## Fig. 4b

Europäisches
Patentamt

European
Patent Office

Office européen
des brevets

# EUROPEAN SEARCH REPORT

Application Number

EP 17 19 0822

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | DAVID GRANGE ET AL: "Atomic Layer Deposition (ALD): une technologie prometteuse pour l'industrie horlogère", BULLETIN DE LA SOCIÉTÉ SUISSE DE CHRONOMÉTRIE,, no. 81, 1 May 2016 (2016-05-01), pages 43-46, XP001597373, * Abstract and sections L'ALD à la Haute Ecole Arc; L'ALD et l'horlogerie * ----- | 1-13 | INV. C23C16/40 C23C16/455 G04B19/10 G04B37/22 |
| X | US 2015/185701 A1 (TOBENAS BORRON SUSANA DEL CARMEN [CH]) 2 July 2015 (2015-07-02) * paragraphs [0001], [0024], [0027] - [0028], [0046], [0049], [0066] * ----- | 1-13 | |
| X,D | US 2017/068219 A1 (DUBOIS PHILIPPE [CH]) 9 March 2017 (2017-03-09) * paragraphs [0046], [0064], [0066] * ----- | 1-13 | |
| | | | **TECHNICAL FIELDS SEARCHED (IPC)**<br><br>C23C<br>G04B |

The present search report has been drawn up for all claims

| Place of search | Date of completion of the search | Examiner |
|---|---|---|
| The Hague | 20 February 2018 | Peijzel, Paul |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 17 19 0822

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2018

| Patent document cited in search report | | | Publication date | Patent family member(s) | | | Publication date |
|---|---|---|---|---|---|---|---|
| US 2015185701 | A1 | | 02-07-2015 | CN | 104583880 | A | 29-04-2015 |
| | | | | EP | 2870512 | A1 | 13-05-2015 |
| | | | | JP | 2015522152 | A | 03-08-2015 |
| | | | | US | 2015185701 | A1 | 02-07-2015 |
| | | | | WO | 2014006229 | A1 | 09-01-2014 |
| US 2017068219 | A1 | | 09-03-2017 | CN | 106502078 | A | 15-03-2017 |
| | | | | EP | 3141520 | A1 | 15-03-2017 |
| | | | | JP | 2017053855 | A | 16-03-2017 |
| | | | | KR | 20170030062 | A | 16-03-2017 |
| | | | | TW | 201718391 | A | 01-06-2017 |
| | | | | US | 2017068219 | A1 | 09-03-2017 |

EPO FORM P0459

For more details about this annex : see Official Journal of the European Patent Office, No. 12/82

## REFERENCES CITED IN THE DESCRIPTION

**Patent documents cited in the description**

- CH 706915 A
- FR 2797995 A1
- EP 3002638 A
- EP 3141520 A

**Non-patent literature cited in the description**

- **N.D. HOIVIK et al.** *Sensor and Actuators A,* 2003, vol. 103, 100-108
- **D. GRANGE et al.** *Atomic Layer Deposition (ALD): une technologie prometteuse pour l'industrie horlogère,* May 2016, vol. 43 (81
- **N. D. HOIVIK et al.** Atomic layer deposited protective coating for micro-electromechanical systems. *Sensor and Actuators A,* 2003, vol. 103, 100-108